(19) Europäisches Patentamt
European Patent Office
Office européen des brevets

(11) **EP 3 542 401 B1**

(12) **FASCICULE DE BREVET EUROPEEN**

(45) Date de publication et mention
de la délivrance du brevet:
**09.12.2020 Bulletin 2020/50**

(21) Numéro de dépôt: **17800915.5**

(22) Date de dépôt: **08.11.2017**

(51) Int Cl.:
*H01L 29/778* (2006.01)          *H01L 29/872* (2006.01)
*H01L 29/417* (2006.01)          *H01L 29/205* (2006.01)

(86) Numéro de dépôt international:
**PCT/FR2017/053048**

(87) Numéro de publication internationale:
**WO 2018/091799 (24.05.2018 Gazette 2018/21)**

(54) **COMPOSANT ÉLECTRONIQUE À HÉTÉROJONCTION À HAUTE MOBILITÉ ÉLECTRONIQUE**

ELEKTRONISCHES BAUTEIL MIT EINEM HETEROÜBERGANG MIT HOHER ELEKTRONENMOBILITÄT

ELECTRONIC COMPONENT WITH A HIGH-ELECTRON-MOBILITY HETEROJUNCTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.11.2016 FR 1661026**

(43) Date de publication de la demande:
**25.09.2019 Bulletin 2019/39**

(73) Titulaire: **Commissariat à l'Energie Atomique et aux Energies Alternatives 75015 Paris (FR)**

(72) Inventeur: **MORVAN, Erwan 38160 Montagne (FR)**

(74) Mandataire: **Guérin, Jean-Philippe Innovation Competence Group 310 avenue Berthelot 69372 Lyon Cedex 08 (FR)**

(56) Documents cités:
**US-A1- 2013 248 873**

- **AKIRA NAKAJIMA ET AL: "GaN-Based Super Heterojunction Field Effect Transistors Using the Polarization Junction Concept", IEEE ELECTRON DEVICE LETTERS, IEEE SERVICE CENTER, NEW YORK, NY, US, vol. 32, no. 4, 1 avril 2011 (2011-04-01), pages 542-544, XP011363948, ISSN: 0741-3106, DOI: 10.1109/LED.2011.2105242**

- **MIYOSHI MAKOTO ET AL: "Device characteristics and performance estimation of nearly lattice-matched InAlN/AlGaN heterostructure field-effect transistors", JOURNAL OF VACUUM SCIENCE & TECHNOLOGY B: MICROELECTRONICS AND NANOMETER STRUCTURES, AMERICAN INSTITUTE OF PHYSICS, 2 HUNTINGTON QUADRANGLE, MELVILLE, NY 11747, vol. 34, no. 5, 25 août 2016 (2016-08-25), XP012210758, ISSN: 2166-2746, DOI: 10.1116/1.4961908 [extrait le 2016-08-25]**

- **JIA LIFANG ET AL: "AlGaN/GaN Schottky Diode Fabricated by Au Free Process", IEEE ELECTRON DEVICE LETTERS, IEEE SERVICE CENTER, NEW YORK, NY, US, vol. 34, no. 10, 1 octobre 2013 (2013-10-01), pages 1235-1237, XP011527882, ISSN: 0741-3106, DOI: 10.1109/LED.2013.2278337 [extrait le 2013-09-23]**

- **CHOI Y ET AL: "C-doped semi-insulating GaN HFETs on sapphire substrates with a high breakdown voltage and low specific on-resistance", JOURNAL OF VACUUM SCIENCE AND TECHNOLOGY: PART B, AVS / AIP, MELVILLE, NEW YORK, NY, US, vol. 25, no. 6, 15 octobre 2007 (2007-10-15), pages 1836-1841, XP012105379, ISSN: 1071-1023, DOI: 10.1116/1.2794058**

- FONTSER A ET AL: "Temperature dependence of Al/Ti-based Ohmic contact to GaN devices: HEMT and MOSFET", MICROELECTRONIC ENGINEERING, ELSEVIER PUBLISHERS BV., AMSTERDAM, NL, vol. 88, no. 10, 20 juin 2011 (2011-06-20) , pages 3140-3144, XP028293384, ISSN: 0167-9317, DOI: 10.1016/J.MEE.2011.06.015 [extrait le 2011-06-26]

- HAJLASZ M ET AL: "Sheet resistance under Ohmic contacts to AlGaN/GaN heterostructures", APPLIED PHYSICS LETTERS, A I P PUBLISHING LLC, US, vol. 104, no. 24, 16 juin 2014 (2014-06-16), XP012186575, ISSN: 0003-6951, DOI: 10.1063/1.4884416 [extrait le 1901-01-01]

**Description**

L'invention concerne les composants électroniques à heterojonction à haute mobilité électronique pour des applications de puissance, et en particulier l'optimisation de tels composants électroniques et de leur courant à l'état passant.

De nombreuses applications électroniques nécessitent dorénavant une amélioration de performances surtout dans l'électronique embarquée à destination de l'automobile et des transports terrestres, dans l'aéronautique, dans les systèmes médicaux ou dans des solutions domotiques par exemple. Ces applications nécessitent pour la plupart des commutateurs pour forte puissance fonctionnant dans des gammes de fréquences souvent supérieures au megahertz.

Historiquement, des commutateurs de puissance ont longtemps fait appel à des transistors à effet de champ basés sur un canal semi-conducteur, le plus souvent du silicium. Pour des fréquences plus faibles, les transistors à jonction sont préférés car ils supportent des densités de courant plus élevées. Cependant, du fait de la tension de claquage relativement limitée de chacun de ces transistors, les applications de puissance nécessitent l'utilisation d'un grand nombre de transistors en série, ou des transistors plus longs, ce qui aboutit à une résistance de passage plus élevée. Les pertes à travers ces transistors en série sont considérables, aussi bien en régime établi qu'en commutation.

Une alternative pour des commutateurs de puissance, notamment à hautes fréquences, est l'utilisation des transistors HEMT. Un tel transistor inclut la superposition de deux couches de matériaux semi-conducteurs ayant des bandes interdites différentes qui forment un puit quantique à leur interface. Des électrons sont confinés dans ce puits quantique pour former un gaz bidimensionnel d'électrons. Pour des raisons de tenue en haute tension et en température, ces transistors sont choisis de façon à présenter une large bande d'énergie interdite.

En particulier, des transistors HEMT sont fréquemment formés à partir de la superposition de couches de matériaux semi conducteurs en alliages binaires ou ternaires de nitrures d'élément III (par exemple AlGaN, InAlN, GaN, AlN...). Une couche de gaz d'électrons est formée à proximité de l'interface entre ces couches de matériaux semi conducteurs.

Dans la plupart des configurations, un tel transistor comporte une électrode de source métallique et une électrode de drain métallique formées à l'aplomb de la couche de gaz d'électrons. Ces électrodes forment les accès en courant du transistor HEMT. Une électrode de grille est formée entre les électrodes de source et de drain et permet de façon connue en soi de contrôler le courant qui passe dans la couche de gaz d'électrons entre les électrodes de source et de drain.

Pour des niveaux de tension intermédiaires (typiquement entre 100 et 1200 volts), la résistance de contact linéique entre une électrode de source/drain est un paramètre prépondérant pouvant limiter le courant à l'état passant du transistor HEMT. La résistance de contact linéique (en ohm.cm), désignée par Rc, représente une synthèse de plusieurs paramètres différents :

- la performance intrinsèque du contact, représentée par la résistance spécifique de contact désignée par pc (en ohm.cm$^2$, pour une température de fonctionnement Tm donnée du composant). La résistance spécifique de contact est représentative de la qualité du transport électronique vertical à l'interface entre le métal de l'électrode et le gaz d'électrons. pc est dépendante de la technologie de fabrication de l'électrode. pc vaut par exemple $10^{-5}$ ohm.cm$^2$ pour une technologie de transistors de type GaN sur Silicium ;
- la longueur de transfert LT (pour une température de fonctionnement Tm donnée), représentative de la longueur utile du contact pour garantir une distribution optimale du courant de l'électrode vers la couche de gaz d'électrons ;
- la longueur L (pour une température de fonctionnement Tm donnée) dite d'ouverture de l'électrode ;
- la résistance par carré (ou résistance de couche) R2Deg (pour une température de fonctionnement Tm donnée) de la couche de gaz d'électrons.

Un modèle dit TLM de la résistance d'électrode ou de contact ohmique Rc s'exprime comme suit (Rc est la résistance de contact linéique, ici exprimée en Ohm.mm, correspondant à la résistance de contact brute normalisée à la largeur du contact, W):

$$Rc = (\coth (L/LT))^* \sqrt{(pc^*R2Deg)}$$

$$LT = \sqrt{(pc/R2Deg)}$$

On peut faire les approximations suivantes :

$$\text{Si } L \gg L_T, \; R_c \approx \rho_c/L_T$$

$$\text{Si } L \ll L_T, \; R_c \approx \rho_c/L$$

Globalement, pour pc donné, plus R2Deg est faible, plus les lignes de courant vont s'étaler loin du bord de l'électrode, et plus LT prend une valeur élevée. Par exemple, pour une technologie d'électrode caractérisée par pc = 2.5e-5 Ohm.cm$^2$ et une hétérojonction caractérisée par R2Deg = 400 Ohm, on obtient LT = 2.5$\mu$m. Si L>> LT, Rc = 10$^{-3}$ Ohm.m ou 1 Ohm.mm.

On cherche généralement à minimiser la contribution de la résistance de contact Rc des électrodes à la résistance totale à l'état passant Ron, en limitant celle-ci par exemple à 10 %. Ceci est obtenu en respectant le critère L>> LT.

Pour une technologie de transistors de type GaN sur Silicium, l'utilisation d'Au dans les électrodes est impossible si l'on souhaite conserver un transistor compatible avec la technologie CMOS. Par conséquent, le contact ohmique présente un pc plus élevé, donc un LT plus élevé. Les électrodes d'un tel transistor HEMT présentent donc généralement une longueur d'ouverture L au moins égale à 2 fois LT, afin de limiter la contribution de la résistance de contact Rc à la résistance Ron.

Un tel transistor HEMT présente un inconvénient important. D'une part, la résistance de la couche de gaz d'électrons est fortement liée à la mobilité électronique. La mobilité électronique dans la couche de gaz d'électrons chutant fortement avec la température, la résistance à l'état passant Ron est extrêmement sensible à la température. Le comportement du transistor est alors fortement modifié en fonction de sa température de fonctionnement. D'autre part, la résistance spécifique à l'état passant Ronsp n'est pas forcément optimisée pour des valeurs élevées de température.

Pour leur tension de claquage, leur temps de commutation ou leurs faibles pertes à l'état passant, les diodes à hétérojonction connaissent un développement croissant. Cependant, les électrodes de contact ohmique de telles diodes induisent les mêmes problématiques que les électrodes des transistors HEMT.

Le document 'GaN-Based Super Heterojunction Field Effect Transistors Using the Polarization Junction Concept' par Akira Nakajima et Al, publié dans IEEE ELECTRON DEVICE LETTERS, 20110401 IEEE SERVICE CENTER, NEW YORK, NY, US, Vol:32,Nr:4,Page(s):542 - 544, décrit une optimisation des transistors à haute mobilité électronique par utilisation d'une jonction de polarisation dans une couche d'AlGaN non intentionnellement dopée. A l'état Off, des charges de polarités opposées se compensent afin d'améliorer la résistance de claquage du transistor.

Le document 'Device characteristics and performance estimation of nearly lattice-matched InAlN/AlGaN heterostructure field-effect transistors', par Miyoshi Makoto et al., publié dans Journal of Vacuum Science & Technology B: Microelectronics and Nanometer Structures, 20160825 American Institute of Physics, 2 Huntington Quadrangle, Melville, NY 11747, Vol:34,Nr:5, décrit la simulation d'un transistor à haute mobilité électronique de type AlGaN/GaN. Le document présente des résultats de simulation de résistance à l'état passant des résistances de contact des électrodes.

Le document 'AlGaN/GaN Schottky Diode Fabricated by Au Free Process', par Jia Lifang et al., IEEE ELECTRON DEVICE LETTERS, 20131001 IEEE SERVICE CENTER, NEW YORK, NY, US, Vol:34,Nr:10,Page(s):1235 - 1237, décrit des iodes à hétérojonction ayant des contacts ohmiques ou Schottky. Des contacts ohmiques avec un empilement Ti/AIT/Ti/TiN ont été réalisés, pour obtenir des propriétés de contact similaires à des contacts utilisant de l'or.

Le document 'C-doped semi-insulating GaN HFETs on sapphire substrates with a high breakdown voltage and low specific on-resistance', par Choi Y et al., publié dans JOURNAL OF VACUUM SCIENCE AND TECHNOLOGY: PART B, 20071015 AVS / AIP, MELVILLE, NEW YORK, NY, US, Vol:25,Nr:6,Page(s):1836 - 1841, décrit des transistors à hétérojonction à forte tension de claquage. Une faible résistance à l'état passant est obtenue en utilisant une couche tampon en GaN dopée au Carbone, positionnée sur un substrat de saphir.

L'invention vise à résoudre un ou plusieurs de ces inconvénients. L'invention porte ainsi sur un composant électronique à hétérojonction à haute mobilité électronique, tel que défini dans la revendication 1 annexée.

L'invention porte également sur les variantes des revendications dépendantes. L'homme du métier comprendra que chacune des caractéristiques des variantes des revendications dépendantes peut être combinée indépendamment aux caractéristiques de la revendication indépendante, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :

- la figure 1 est une vue en coupe schématique d'un exemple de transistor HEMT selon un mode de réalisation de l'invention ;
- la figure 2 illustre un exemple d'évolution d'une résistance linéique d'un gaz d'électrons en fonction de la température ;

- la figure 3 illustre un exemple d'évolution de la mobilité électronique dans une couche de gaz d'électrons en fonction de la température ;
- la figure 4 illustre un exemple d'évolution de la résistance spécifique de contact à l'interface entre un contact métallique et une couche de gaz d'électrons en fonction de la température;
- la figure 5 illustre différentes évolutions de la résistance de contact en fonction de la température et de différentes longueurs de contacts ;
- la figure 6 illustre différentes évolutions de la résistance de contact en fonction de la température et de ratios de longueurs de contacts ;
- la figure 7 illustre un exemple d'évolution de la résistance spécifique à l'état passant d'un transistor, en fonction de la température et de différentes longueurs de contact ;
- la figure 8 illustre la résistance spécifique à l'état passant d'un transistor, en fonction des longueurs de contact, pour différentes valeurs de température ;
- la figure 9 illustre un exemple de diagramme du pourcentage de l'augmentation de la résistance spécifique à l'état passant en fonction de paramètres ;
- la figure 10 illustre un exemple de résistance spécifique à l'état passant pour des paramètres optimisant sa stabilité dans une plage de température donnée ;
- la figure 11 est une vue en coupe schématique d'un exemple de transistor HEMT selon un autre mode de réalisation de l'invention ;
- la figure 12 est une vue en coupe schématique d'un exemple de diode à hétérojonction selon un autre mode de réalisation de l'invention.

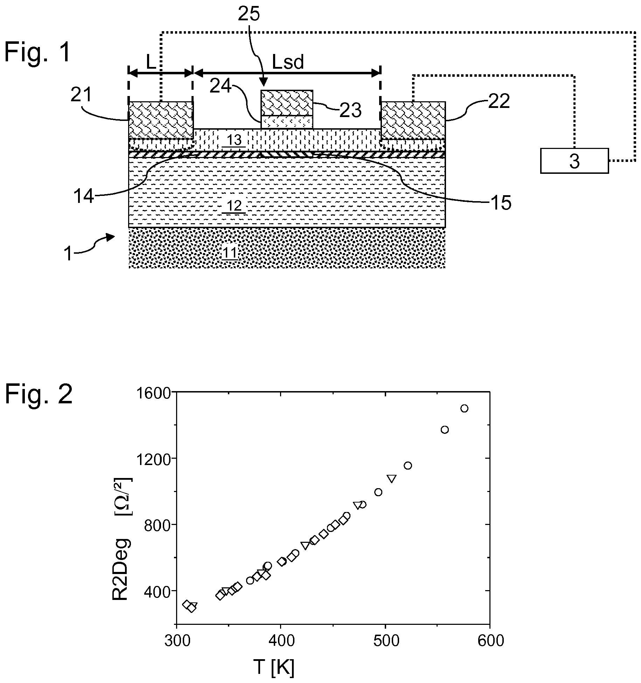

La figure 1 est une vue en coupe transversale schématique d'un exemple de transistor 1 de type HEMT (également désigné par le terme de transistor à effet de champ à haute mobilité d'électrons) selon un mode de réalisation de l'invention.

Le transistor 1 comporte un substrat 11, éventuellement une couche tampon non illustrée et disposée sur le substrat 11, une couche semi-conductrice 12 (par exemple de type III-V, par exemple en nitrure d'élément III, typiquement du GaN), une couche semi-conductrice 13 en un autre matériau (par exemple de type III-V, par exemple en nitrure d'élément III, typiquement du AlGaN, dont la bande interdite est supérieure à celle de la couche 12) et une couche de gaz d'électrons 14 intrinsèquement formée de façon connue en soi dans la couche 12 et à proximité de l'interface entre les couches 12 et 13. La couche de gaz d'électrons 14 est destinée à la conduction du transistor 1 à l'état passant. Le transistor 1 est ainsi du type à conduction horizontale, c'est-à-dire sensiblement coplanaire au substrat.

Une fine couche d'un autre matériau semi-conducteur (non illustrée) peut avantageusement être interposée entre les couches 12 et 13, de façon connue en soi (par exemple une couche d'AlN de 1 nm d'épaisseur entre une couche de GaN et une couche d'AlGaN).

Le substrat 11 peut être un isolant ou un semiconducteur de type silicium intrinsèque ou dopé. Le substrat 11 pourra par exemple être de type silicium à orientation de maille (111). Le substrat 11 peut également être du carbure de silicium, ou du saphir. Le substrat 11 peut présenter une épaisseur de l'ordre de 650 $\mu$m, typiquement comprise entre 500 $\mu$m et 2mm suivant le diamètre des substrats.

Une couche tampon peut être déposée entre le substrat 11 et la couche semi conductrice 12, pour gérer les contraintes mécaniques (liées aux différences de paramètres de maille et de coefficient d'expansion thermique, CTE) entre le substrat 11 et cette couche semi conductrice 12. La couche tampon peut typiquement être en nitrure d'aluminium, en AlGaN à proportion d'Al décroissante ou en super-réseau de GaN/AlN.

La couche semi conductrice 12 peut typiquement présenter une épaisseur comprise entre 100nm et 10$\mu$m. La couche semi conductrice 12 peut être formée de façon connue en soit par épitaxie sur une couche tampon ou sur le substrat 11. La couche semi conductrice 12 est typiquement un alliage binaire de nitrure d'élément III, par exemple du GaN.

La couche semi conductrice 13, typiquement appelée couche barrière, peut typiquement présenter une épaisseur comprise entre 5nm et 40nm, par exemple de 25nm. La couche semi conductrice 13 peut être formée de façon connue en soit par épitaxie sur la couche semi conductrice 12. La couche semi conductrice 13 est typiquement un alliage ternaire de nitrure d'élément III, par exemple de l'AlGaN ou alliage binaire de nitrure d'élément III, par exemple du AlN. La couche 13 doit avoir une bande interdite supérieure à celle de la couche 12.

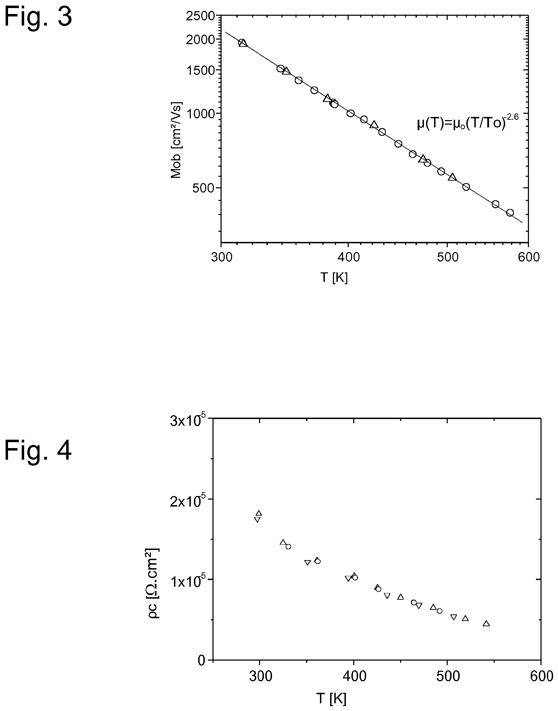

Le transistor 1 comporte de façon connue en soi des contacts métalliques 21 et 22, formant des électrodes de conduction. Les contacts métalliques 21 et 22 sont disposés sur la couche semi conductrice 13. Les contacts métalliques 21 et 22 sont disposés à l'aplomb de la couche de gaz d'électrons 14. Les contacts métalliques 21 et 22 sont chacun connectés électriquement à la couche de gaz d'électrons 14, par l'intermédiaire d'une connexion électrique verticale (caractérisée par une résistance spécifique de contact détaillée en référence à la figure 4).

Les contacts 21 et 22 sont ici avantageusement formés chacun dans un évidement respectif de la couche 13. L'un de ces contacts métalliques est un contact de source, l'autre de ces contacts métalliques est un contact de drain du transistor 1. Une grille de commande 25 est positionnée sur la couche semi conductrice 13 entre les contacts métalliques 21 et 22.

La grille de commande 25 comporte ici un oxyde de grille 24 disposé sur la couche semi conductrice 13. L'oxyde de grille 24 est isolant électriquement. Un métal de grille 23 est disposé sur l'oxyde de grille 24. L'invention s'applique également à tout type de grille de transistor, grille de type MIS, grille de type transistor normalement ouvert ou grille de type normalement fermé.

Une zone de canal 15 est formée à l'aplomb de la grille 25, dans la couche de gaz d'électrons 14. De façon connue en soi, cette zone de canal 15 est sélectivement rendue passante ou isolante, en fonction de l'état de polarisation sur la grille 25.

Selon le modèle dit TLM, on exprime :

- la longueur de transfert $LT = \sqrt{(\rho c/R2Deg)}$ (pour une température de fonctionnement Tm donnée du composant, par exemple 425°C), représentative de la longueur utile du contact pour garantir une distribution optimale du courant d'une des électrodes 21 et 22 vers la couche de gaz d'électrons 14 (le courant qui descend d'un contact vers la couche de gaz d'électrons décroit exponentiellement depuis le bord du contact avec une longueur caractéristique LT);
- la résistance d'électrode $Rc = (\coth (L/LT)) * \sqrt{(\rho c * R2Deg)}$ (pour une température de fonctionnement Tm donnée du composant).

pc étant la valeur de la fonction pc(T) pour une température de fonctionnement Tm donnée du composant (résistance spécifique des contacts 21 et 22), R2Deg étant la valeur de la fonction R2Deg(T) pour la température de fonctionnement Tm du composant (résistance linéique de la couche de gaz d'électrons 14).

On n'a pas illustré les dimensions du transistor 1 selon une direction perpendiculaire au plan de coupe. Cette dimension correspond à la largeur W du transistor 1. Le transistor 1 présentant usuellement une largeur constante du contact 21 jusqu'au contact 22, sa surface active (et son encombrement selon cette direction) est usuellement définie par W * (Pitch), avec pitch la longueur ou le pas du transistor élémentaire, définie par la distance entre les deux extrémités distales des contacts 21 et 22.

Les contacts 21 et 22 pouvant être partagés avec d'autres transistors accolés, la longueur L prise en compte pour le dimensionnement d'un tel contact mutuel correspondra à la moitié de la longueur effective de ce contact, cette longueur effective correspondant alors également à la longueur de l'ouverture par gravure dans la couche de passivation.

La figure 2 illustre un exemple de d'évolution de la résistance de couche d'un gaz d'électrons R2Deg(T) en fonction de la température. Comme illustré, la résistance R2Deg(T) augmente fortement avec la température. Cela peut fortement affecter la sensibilité en température du fonctionnement du transistor 1, en altérant sa résistance à l'état passant. Entre une température de 293°K et une température de 573°K, la résistance R2Deg est ainsi multipliée par 5.

La figure 3 illustre la mobilité électronique de la couche de gaz d'électrons 14 en fonction de la température. La mobilité électronique chute fortement avec la température, ce qui explique l'augmentation de la résistance R2Deg de la couche de gaz d'électrons 14 avec la température. La mobilité électronique $\mu$ en fonction de la température a ici été modélisée par la relation suivante : $\mu = \mu_{0*}(T/To)^{-2.6}$ (avec T0 la température de référence pour la mobilité). Une telle augmentation de la résistance R2Deg avec la température semble indissociable des principes physiques de conduction dans une couche de gaz d'électrons associée à l'hétérojonction $Al_xGa_{(1-x)}N/GaN$ (diffusion des électrons par les phonons optiques).

La figure 4 illustre l'évolution de la fonction pc(T) avec la température (la résistance spécifique de contact qui caractérise le transport électronique entre le métal et la couche de gaz d'électrons de l'hétérojonction sous-jacente). La fonction pc(T) décroît fortement avec la température. Selon l'invention, cette propriété est exploitée pour compenser l'augmentation de la fonction R2Deg(T), les contacts métalliques 21 et 22 présentant chacun une longueur de contact L telle que $L \leq 1,5 * \sqrt{(\rho c/R2Deg)}$, et en particulier telle que $L \leq 1 * \sqrt{(\rho c/R2Deg)}$. La fonction pc(T) peut être modélisée par une loi exponentielle de type $a * e^{(b/T)}$, avec a et b des constantes.

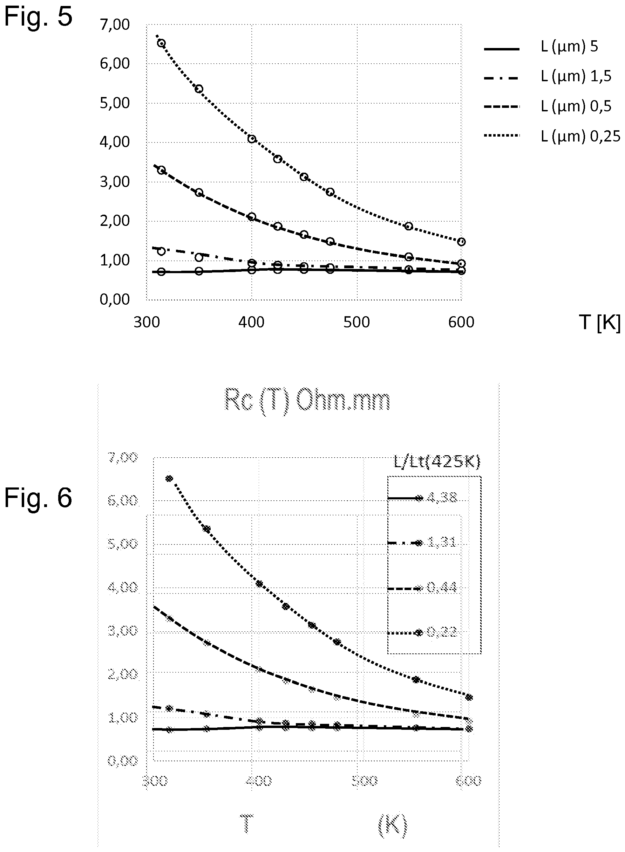

La figure 5 illustre différentes évolutions de résistances de contact Rc en fonction de la température, pour différentes valeurs de longueurs de contact L. La valeur L de 5$\mu$m est ici supérieure à 2 * LT. La valeur de 1,5$\mu$m est ici au plus égale à 1,5 *LT. La figure 6 illustre l'évolution de la résistance de contact en fonction de la température, ici en fonction du ratio L/Lt.

On constate que plus le contact ohmique est tronqué, plus la résistance de contact Rc(T) diminue fortement avec la température. Cela est dû à la fois au fait que la résistance spécifique de contact, $\rho c$ (T) diminue avec la température et au fait que la troncature diminue avec la température (Lt(T) diminue). C'est cette diminution de Rc(T) qui permet de compenser l'augmentation de R2Deg(T).

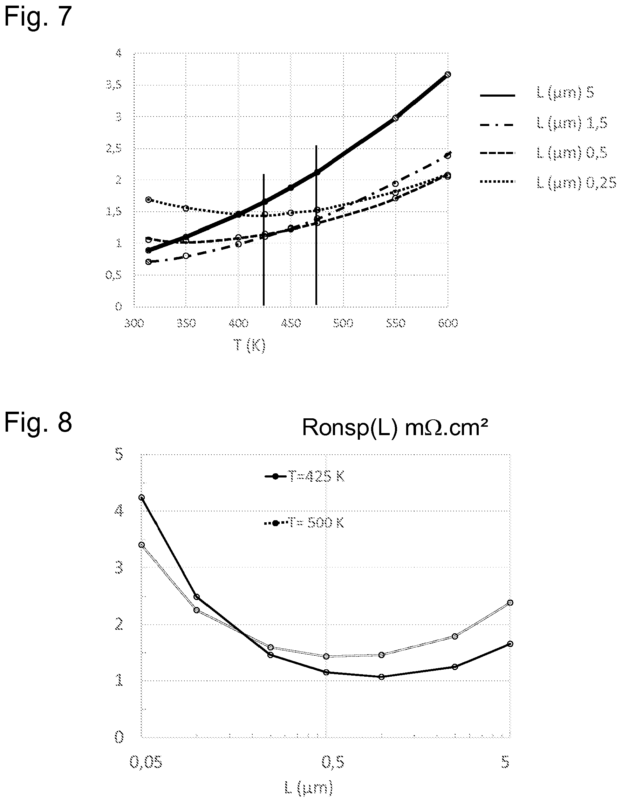

La figure 7 illustre un exemple d'évolution de la résistance spécifique d'un transistor 1 à l'état passant, en fonction de la température, en fonction de différentes valeurs de L. On constate qu'un transistor avec des contacts selon l'invention permet avantageusement de réduire la sensibilité de sa résistance spécifique à la température et de réduire la valeur de Ronsp à température élevée (température de fonctionnement).

On constate que la sensibilité à la température de la résistance spécifique d'un transistor 1 à l'état passant est faible lorsque L est au plus égale à 0,9 * LT. On constate en particulier que la sensibilité à la température de la résistance spécifique d'un transistor 1 à l'état passant est particulièrement réduite lorsque L est au plus égale à 0,5 * LT. Ainsi, pour réduire la sensibilité à la température de la résistance spécifique du transistor 1 à l'état passant, on réduit avantageusement au maximum la longueur de contact L. L'invention va à l'encontre de l'orientation technique habituelle de l'homme du métier, à savoir réduire a priori la contribution de la résistance de contact à la résistance à l'état passant, en augmentant la longueur L des contacts métalliques, en particulier lorsqu'on utilise des matériaux des contacts conduisant à une plus grande résistivité (ou résistance) spécifique de contact.

Comme illustré en référence à la figure 8, on peut également réduire la résistance spécifique à l'état passant du transistor 1, à une température donnée de fonctionnement. Par ailleurs, comme illustré à la figure 8, la résistance spécifique du transistor 1 est relativement constante avec de faibles variations de la longueur de contact L autour d'une valeur correspondant à la valeur optimale. Ainsi, la résistance spécifique du transistor 1 est relativement peu sensible à des dispersions de son procédé de fabrication affectant sa longueur de contact L. Cette résistance spécifique du transistor 1 peut s'exprimer comme suit :

$$Ronsp\ (T, L) = (R_{2DEG}(T) * Lsd + 2 * Rc(T,L)) * pitch$$

Pour disposer d'une résistance spécifique minimale à une température Tn de fonctionnement donnée, on choisira une troncature moins marquée correspondant à un optimum à cette température. A partir du diagramme de la figure 8, on peut déduire :

- une valeur L optimale de 0,65$\mu$m à une température de 500 K (Ronsp = 1,43mohm.cm$^2$) ;
- une valeur L optimale de 1$\mu$m à une température de 425 K (Ronsp = 1,07mohm.cm$^2$).

La recherche de la valeur L optimale pour obtenir la résistance spécifique minimale à une température donnée peut être réalisée analytiquement, en recherchant une solution approchée.

Pour cela, on réalise les approximations suivantes :

Le calcul de cotangente hyperbolique coth(x) intervenant dans le calcul de Rc est remplacé par son développement en série valable pour x < 1 (à 1,5% près :

$$Coth\ (x) \approx (1/x) + (x/3)$$

On utilise les deux premiers termes du développement pour ne pas aboutir à une incohérence du résultat.

En considérant L << Lsd (le contact ohmique occupe par principe une place réduite par rapport à la partie active du composant).

Pour simplifier les notations :

pc(Tn) = $\rho$
R2Deg(Tn) =R
LT(Tn) = LT
Rc(Tn)= Rc

Par conséquent :

$$LT = \sqrt{(pc(Tn)/R2Deg(Tn))} = \sqrt{(\rho/R)}$$

On simplifie Rc à partir du développement de la cotangente hyperbolique

$$Rc = coth(L/LT) * \sqrt{(\rho*R)} \approx ((LT/L)+(L/(3*LT))) * \sqrt{(\rho*R)}$$

En remplaçant LT par l'expression précédente :

$$Rc \approx (((\sqrt{(\rho/R)})/L)+(L/(3*\sqrt{(\rho/R)}))) * \sqrt{(\rho*R)} = (\rho/L) + ((L*R)/3)$$

En introduisant cette expression de Rc dans Ronsp(Tn) :

$$Ronsp(Tn, L) = ((R * Lsd) +2 * Rc)*(Lsd+(2*L)) =$$
$$((R * Lsd) + (2 *((\rho/L) + ((L*R)/3))))* (Lsd+(2*L))$$

$$Ronsp(Tn, L)=$$
$$R*Lsd^2 + 2*R*Lsd*L+2*Lsd*\rho/L + 2*Lsd * L*R/3 +4*\rho +4*R*L^2/3$$

En dérivant Ronsp(Tn,L) par rapport à L, on obtient:

$$dRonsp(Tn,L)/dL = 2*R*Lsd + 2*R*Lsd/3 -2*Lsd*\rho/L^2 +8R*L/3 =$$
$$8*R*Lsd/3 -2*Lsd*\rho/L^2 +8R*L/3$$

On calcule donc le minimum de Ronsp(Tn,L) en recherchant les valeurs nulles de sa dérivée, soit

$$8*R*Lsd/3 -2*Lsd*\rho/L^2 +8R*L/3 = 0,$$

soit

$$Lsd*L^2 - 3*Lsd* \rho /(4*R) +L^3=0$$

Soit

$$L^2*(Lsd+L)=3*Lsd* \rho/(4*R)$$

En approximant avec Lsd >>L :
Soit

$$L^2=3* \rho/(4*R)$$

On obtient alors $L=((\sqrt{3})/2) * \sqrt{(\rho/R)} \approx 0{,}86 * LT$

On peut par exemple choisir une valeur de L comprise entre 0,8 et 0,9 * LT. On désignera par Lopt la valeur de longueur L obtenue.

Dans certains cas, la résistance R2DEG sous le contact ohmique est supérieure à celle entre les plots de contact ohmique, si le procédé de fabrication du contact ohmique modifie le gaz d'électron sous le contact. On constate aisément que le calcul développé ci-dessus reste valide car L reste suffisamment petit devant Lsd. La condition pour que cette approximation reste valide si l'inégalité suivante est respectée :

$$L<<Lsd*(3*(((3*R1)/R2)+1)/4)$$

Avec R1 la résistance de la couche de gaz d'électrons au-delà du contact et R2 la résistance de la couche de gaz d'électrons sous le contact.

Le calcul de la sensibilité de Ronsp(Tm) en fonction des dispersions sur la valeur L, à partir de la valeur Lopt peut être réalisé comme suit. Pour cela, on peut

$$Ronsp\ (L) \approx$$
$$Ronsp(Lopt) + R'onsp(Lopt)*(L-Lopt)+0,5*R''onsp(Lopt)\ *(L-Lopt)^2$$

développer Ronsp (Tm, L) en série de Taylor autour de la valeur Lopt :

Avec

$$R'onsp(Lopt) = dRonsp(Lopt)/dL$$

et

$$R''onsp(Lopt)= d^2Ronsp(Lopt)/dL^2$$

R'onsp(Lopt) étant nulle pour le minimum recherché, la relation peut s'exprimer :

$$Ronsp(L) \approx Ronsp(Lopt) + 0,5*R''onsp(Lopt)\ *(L-Lopt)^2$$

La sensibilité peut ainsi s'exprimer comme suit :

$$(Ronsp\ (L) - Ronsp(Lopt))/\ Ronsp(Lopt) \approx$$
$$0,5*R''onsp(Lopt)\ *(L-Lopt)^2\ /\ Ronsp(Lopt)$$

Pour le calcul du numérateur :

$$R''onsp(L)=d(R'onsp(L))/dL=d(8*R*Lsd/3 -2*Lsd*\rho/L^2 +8R*L/3)/dL=$$
$$4*Lsd*\rho/L^3 + 8R/3$$

Donc

$$R''onsp(Lopt)= 4*Lsd*\rho/Lopt^3 + 8R/3$$

En remplaçant Lopt et p par leur expression aux fonctions de LT, on obtient

$$R''onsp(Lopt)=8*R*(4*Lsd/(\sqrt{3}*LT) +1)/3 \approx 8*R*(4*Lsd/(\sqrt{3}*LT))/3$$

Pour le calcul du dénominateur :

$$Ronsp(Lopt) \approx Lsd*((R*Lsd) +(2*\rho/Lopt)+(2*Lopt*R/3))/3$$

En remplaçant Lopt et p par leur expression aux fonctions de LT, on obtient

$$Ronsp(Lopt) \approx Lsd*R*(Lsd+ 5*LT/\sqrt{3})$$

La sensibilité peut alors s'exprimer comme suit :

$$(R_{onsp}(L) - R_{onsp}(L_{opt}))/ R_{onsp}(L_{opt}) \approx$$
$$3,08*(L-L_{opt})^2 /(L_{sd}*L_T + 2,88*L_T^2)$$

Par exemple, avec $L_{ds}$=10$\mu$m, $L_T$=1$\mu$m et une déviation de 0,1$\mu$m de la valeur de $(L-L_{opt})$, on obtient une sensibilité de 0,24% pour $R_{onsp}$. On obtient alors un contact relativement peu sensible en température aux dispersions de son procédé de fabrication induisant des erreurs sur la valeur de L.

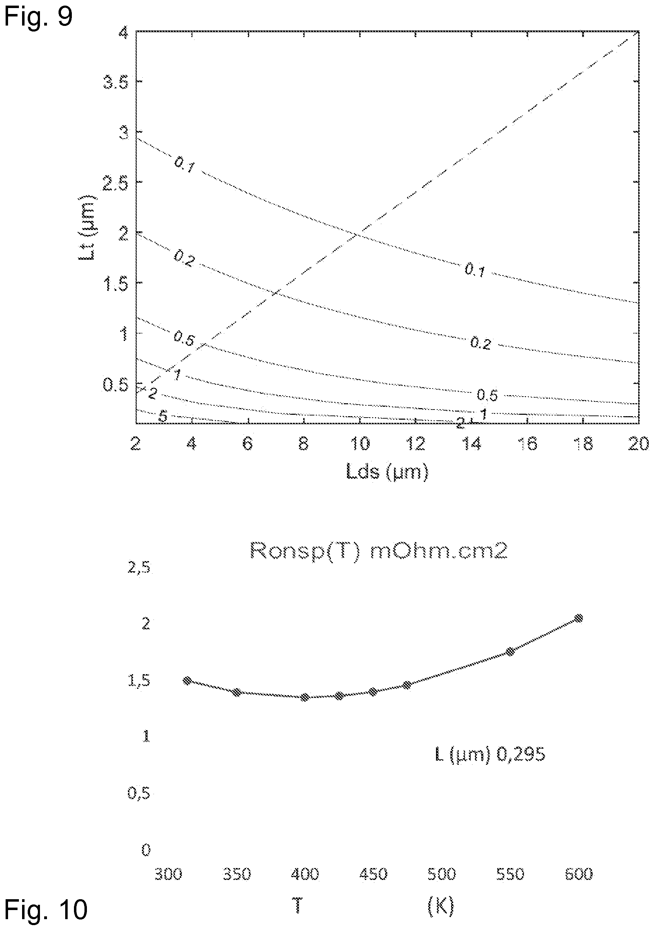

La figure 9 illustre un exemple de diagramme de pourcentage de l'augmentation de $R_{onsp}$ en fonction de $L_{ds}$ et $L_T$. La ligne en trait discontinu correspond à la limite de validité de l'approximation $L_T$>5*$L_{ds}$.

Pour disposer d'une résistance spécifique présentant une dépendance minimale avec la température, on peut réaliser une optimisation numérique comme suit :

On connaît au préalable les modélisations de $\rho c(T)$ et $R_{2DEG}(T)$ pour une technologie donnée, par exemple par des mesures préalables. La valeur L souhaitée peut être résolue numériquement à partir de la relation suivante :

$$R_{onsp}(T_m, L)= (R_{2DEG}(T_m) * L_{sd} + 2 * R_C(T0,L)) * (L_{sd}+2*L)$$

Avec

$$R_C(T)= (\coth (L/L_T(T)))* \sqrt{( \rho c(T)*R2_{Deg}(T))}$$

et

$$L_T(T) = \sqrt{( \rho c(T)/R2_{Deg}(T))}$$

A l'étude du diagramme, on peut constater qu'une valeur de L de 0,5 $\mu$m fournissait une excellente stabilité en température sur une plage comprise entre 425 et 500K.

On va détailler un exemple de calcul permettant de déterminer une valeur de $L_{cib}$ conduisant à une faible sensibilité de $R_{onsp}$ sur une plage de température comprise entre deux bornes T1 et T2.

On désignera par Tm :

$$T_m=(T1 + T2)/2$$

on va chercher la valeur de L qui annule $dR_{onsp}(T)/dT$ en Tm, ce qui correspond à un minimum de variation autour de cette valeur de température.

On repart de l'expression :

$$R_{onsp}(T_m, L) =$$
$$R*L_{sd}^2 + 2*R*L_{sd}*L+2*L_{sd}*\rho/L + 2*L_{sd} * L*R/3 +4*\rho +4*R*L^2/3$$

$$\frac{dR_{onsp}(T,L)}{dT}(T_m) = \left(L_{sd}^2 + \frac{8}{3} * L * L_{sd} + \frac{4}{3}L^2\right)\frac{dR}{dT} + \left(2 * \frac{L_{sd}}{L} + 4\right)\frac{d\rho}{dT}$$

On cherche ainsi la valeur de L qui annule cette dérivée pour la valeur Tm.

On va utiliser les modélisations suivantes pour R(T) et $\rho$(T) :

$$R(T)=a*T^b$$

$$\rho(T)=c*e^{-dT}$$

avec

a=8$^{e-5}$ Ohm/K$^b$ ; b= 2,63517 ; c = 9.23$^{e-5}$ Ohm.cm$^2$ et d=5.5272$^{e-3}$ K$^{-1}$

Avec l'approximation L<<Lsd, on obtient

$$(Lcib) = 2 * \frac{d}{b} * Tm * \frac{LT^2(Tm)}{Lsd}$$

Avec les paramètres détaillés précédemment, on trouve par exemple Lcib=0,295$\mu$m pour Tm= 400K et Lsd=10$\mu$m.

Un exemple de Ronsp(T) est illustré à la figure 10 avec ces paramètres. On constate bien la très faible variation de Ronsp autour de la valeur de T=400K.

On peut exprimer la sensibilité de Ronsp(Tm) par rapport à la valeur L selon la relation suivante :

$$\frac{Ronsp(L) - Ronsp(Lcib)}{Ronsp(Lcib)} \approx \frac{(L - Lcib)^2}{\left(\frac{d}{b}Tm + 1\right) * \left(\frac{2d}{b}Tm\frac{LT^2(Tm)}{Lsd}\right)}$$

Après simulation, avec une erreur L-Lcib de 0,05$\mu$m, Ronsp présente une variation inférieure à 10% pour une très grande plage de valeur de LT et Lsd.

Les contacts métalliques 21 et 22 ne sont avantageusement pas réalisés en or, afin de maintenir le processus de fabrication du transistor 1 compatible CMOS. Les contacts métalliques 21 et 22 sont avantageusement réalisés dans un métal sélectionné dans la liste constituée des alliages de Al/Ti, Al/Ta, Al/V ou Ti/N, du fait d'une résistivité spécifique réduite de l'interface entre l'alliage formé et le gaz d'électrons.

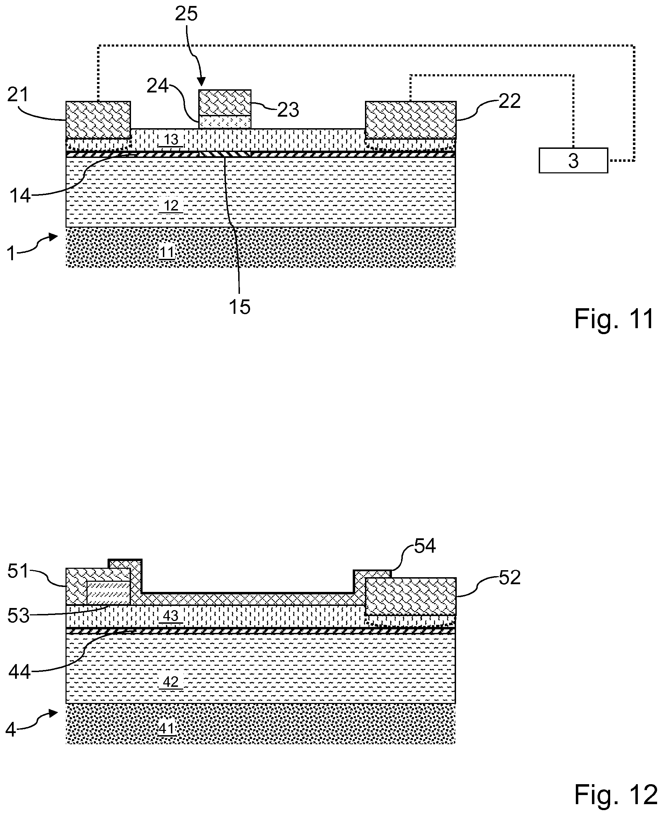

La figure 11 est une vue en coupe transversale schématique d'un exemple de transistor 1 de type HEMT selon un mode de réalisation de l'invention. Ce transistor 1 diffère de celui illustré à la figure 1 par des contacts métalliques 21 et 22 de longueurs différentes. Le contact métallique 22 est ici plus long que le contact métallique 21. Une telle dissymétrie entre les contacts métalliques permet par exemple de favoriser une résistance de contact la plus faible possible pour le contact 22, et un contact 21 compensant la variation de résistance avec la température de la couche de gaz d'électrons. On peut par exemple disposer d'une source présentant une résistance de contact plus élevée que celle du drain.

L'invention s'applique bien entendu à tout autre composant électronique à hétérojonction, à haute mobilité électronique, notamment à une diode à hétérojonction.

La figure 12 est une vue en coupe schématique d'un exemple de diode 4 à hétérojonction à haute mobilité électronique, selon un autre mode de réalisation de l'invention.

La diode 4 comporte un substrat 41, éventuellement une couche tampon non illustrée et disposée sur le substrat 41, une couche semi-conductrice 42 (par exemple de type III-V, par exemple en nitrure d'élément III, typiquement du GaN), une couche semi-conductrice 43 en un autre matériau (par exemple de type III-V, par exemple en nitrure d'élément III, typiquement du AlGaN, dont la bande interdite est supérieure à celle de la couche 42) et une couche de gaz d'électrons 44 intrinsèquement formée de façon connue en soi dans la couche 42 et à proximité de l'interface entre les couches 42 et 43. La couche de gaz d'électrons 44 est destinée à la conduction de la diode 4 à l'état passant. La diode 4 est ainsi du type à conduction horizontale, c'est-à-dire sensiblement coplanaire au substrat 41.

Une fine couche d'un autre matériau semi-conducteur (non illustrée) peut avantageusement être interposée entre les couches 42 et 43, de façon connue en soi (par exemple une couche d'AlN de 1 nm d'épaisseur entre une couche de GaN et une couche d'AlGaN).

Le substrat 41 peut être un isolant ou un semiconducteur de type silicium intrinsèque ou dopé. Le substrat 41 pourra par exemple être de type silicium à orientation de maille (111). Le substrat 41 peut également être du carbure de silicium, ou du saphir. Le substrat 41 peut présenter une épaisseur de l'ordre de 650 $\mu$m, typiquement comprise entre 500 $\mu$m et 2mm suivant le diamètre des substrats.

Une couche tampon peut être déposée entre le substrat 41 et la couche semi conductrice 42, pour gérer les contraintes mécaniques (liées aux différences de paramètres de maille et de coefficient d'expansion thermique, CTE) entre le substrat 41 et cette couche semi conductrice 42. La couche tampon peut typiquement être en nitrure d'aluminium, en AlGaN à proportion d'Al décroissante ou en super-réseau de GaN/AlN.

La couche semi conductrice 42 peut typiquement présenter une épaisseur comprise entre 100nm et 10$\mu$m. La couche semi conductrice 42 peut être formée de façon connue en soit par épitaxie sur une couche tampon ou sur le substrat 41. La couche semi conductrice 42 est typiquement un alliage binaire de nitrure d'élément III, par exemple du GaN.

La couche semi conductrice 43 peut typiquement présenter une épaisseur comprise entre 5nm et 40nm, par exemple de 25nm. La couche semi conductrice 43 peut être formée de façon connue en soit par épitaxie sur la couche semi conductrice 42. La couche semi conductrice 43 est typiquement un alliage ternaire de nitrure d'élément III, par exemple de l'AlGaN ou alliage binaire de nitrure d'élément III, par exemple du AlN. La couche 43 doit avoir une bande interdite supérieure à celle de la couche 42.

La diode 4 comporte de façon connue en soi des contacts métalliques 51 et 52 (respectivement l'anode et la cathode), formant des électrodes de conduction. Le contact métallique est disposé sur la couche semi conductrice 43. Le contact métallique 51 est disposé à l'aplomb de la couche de gaz d'électrons 54. Le contact métallique 52 est connecté électriquement à la couche de gaz d'électrons 44, par l'intermédiaire d'une connexion électrique verticale. Le contact métallique 52 est ici avantageusement formé dans un évidement de la couche 43. Une couche d'isolant 54 est formée sur la couche 43, entre les électrodes 51 et 52. Une zone semi-conductrice 53 à dopage de type P est recouverte par l'électrode 51 et est en contact avec la couche 43.

Le dimensionnement de l'électrode 52 pourra par exemple être identique à celui détaillé pour les contacts 21 et 22 du transistor 1 détaillé précédemment.

## Revendications

1.  Composant électronique à hétérojonction à haute mobilité électronique (1), comprenant :

    - une superposition d'une première couche de matériau semi-conducteur (12) et d'une deuxième couche de matériau semi-conducteur (13), de façon à former une couche de gaz d'électrons (14) à proximité de l'interface entre les première et deuxième couches de matériau semi-conducteur ;
    - des premier et deuxième contacts métalliques (21, 22) d'électrodes de conduction formés sur ladite deuxième couche (13) de matériau semi-conducteur à l'aplomb de la couche de gaz d'électrons ;

    **caractérisé en ce que** :

    au moins un desdits premier et deuxième contacts métalliques présente une longueur de contact L telle que $L \leq 1,5 * \sqrt{(\rho c/R2Deg)}$ ;
    avec pc la résistance spécifique dudit contact métallique avec la couche de gaz d'électrons à 425K, avec R2Deg la résistance par carré dans la couche de gaz d'électrons à 425K.

2.  Composant électronique à hétérojonction à haute mobilité électronique (1, 4) selon la revendication 1, dans lequel au moins un desdits premier et deuxième contacts métalliques (21, 22, 52) présente une longueur de contact L telle que $L \leq 0,9 * \sqrt{(\rho c/R2Deg)}$.

3.  Composant électronique à hétérojonction à haute mobilité électronique (1, 4) selon la revendication 2, dans lequel au moins un desdits premier et deuxième contacts métalliques (21, 22, 52) présente une longueur de contact L telle que $L \leq 0,5 * \sqrt{(\rho c/R2Deg)}$.

4.  Composant électronique à hétérojonction à haute mobilité électronique (1, 4) selon la revendication 2, dans lequel au moins un desdits premier et deuxième contacts métalliques (21, 22, 52) présente une longueur de contact comprise entre $0,8*\sqrt{(\rho c)}/R2Deg$) et $0,9*\sqrt{(\rho c/R2Deg)}$.

5.  Composant électronique à hétérojonction à haute mobilité électronique (1, 4) selon l'une quelconque des revendications précédentes, dans lequel la première couche de matériau semi-conducteur (12, 42) est en GaN, et dans lequel la deuxième couche de matériau semi-conducteur (13, 43) est en AlGaN.

6.  Composant électronique à hétérojonction à haute mobilité électronique (1, 4) selon l'une quelconque des revendications précédentes, dans lequel la distance entre lesdits premier et deuxième contacts métalliques (21, 22, 51, 52) est au plus égale à 20 $\mu$m.

7.  Composant électronique à hétérojonction à haute mobilité électronique (1, 4) selon l'une quelconque des revendications précédentes, dans lequel lesdits premier et deuxième contacts métalliques (21, 22, 51, 52) sont dans un métal sélectionné dans la liste constituée des alliages de Al/Ti, Al/Ta, AlN ou Ti/N.

8. Composant électronique à hétérojonction à haute mobilité électronique (1) selon l'une quelconque des revendications précédentes, dans lequel ladite deuxième couche de matériau semi-conducteur (13) présente des évidements dans lesquels lesdits premiers et deuxièmes contacts (21, 22) sont disposés.

9. Composant électronique à hétérojonction à haute mobilité électronique (1) selon l'une quelconque des revendications précédentes, ce composant électronique étant un transistor à effet de champ à hétérojonction.

10. Composant électronique à hétérojonction à haute mobilité électronique (4) selon l'une quelconque des revendications 1 à 8, ce composant électronique étant une diode à hétérojonction.

11. Système, comprenant :

    - un composant électronique à hétérojonction à haute mobilité électronique (1) selon l'une quelconque des revendications précédentes;
    - une alimentation électrique (3) configurée pour appliquer une différence de potentiel dont l'amplitude maximale est comprise entre 100 et 1200 volts entre les premier et deuxième contacts métalliques (21, 22) dudit composant électronique.

**Patentansprüche**

1. Elektronisches Bauteil mit Heteroübergang mit hoher Elektronenmobilität (1), das enthält:

    - eine Schichtung einer ersten Halbleitermaterialschicht (12) und einer zweiten Halbleitermaterialschicht (13), um eine Elektronengasschicht (14) in der Nähe der Schnittstelle zwischen den ersten und zweiten Halbleitermaterialschichten zu bilden;
    - erste und zweite metallische Kontakte (21, 22) von Leitungselektroden, die auf der zweiten Halbleitermaterialschicht (13) lotrecht zur Elektronengasschicht geformt werden;

    **dadurch gekennzeichnet, dass**:

    mindestens einer der ersten und zweiten metallischen Kontakte eine derartige Kontaktlänge L aufweist, dass gilt $L \leq 1,5*\sqrt{(\rho c/R2Deg)}$;
    mit pc dem spezifischen Widerstand des metallischen Kontakts mit der Elektronengasschicht bei 425K, mit R2Deg dem Flächenwiderstand in der Elektronengasschicht bei 425K.

2. Elektronisches Bauteil mit Heteroübergang mit hoher Elektronenmobilität (1, 4) nach Anspruch 1, wobei mindestens einer der ersten und zweiten metallischen Kontakte (21, 22, 52) eine derartige Kontaktlänge L aufweist, dass gilt $L \leq 0,9*\sqrt{(\rho c/R2Deg)}$.

3. Elektronisches Bauteil mit Heteroübergang mit hoher Elektronenmobilität (1, 4) nach Anspruch 2, wobei mindestens einer der ersten und zweiten metallischen Kontakte (21, 22, 52) eine derartige Kontaktlänge L aufweist, dass gilt $L \leq 0,5*\sqrt{(\rho c/R2Deg)}$.

4. Elektronisches Bauteil mit Heteroübergang mit hoher Elektronenmobilität (1, 4) nach Anspruch 2, wobei mindestens einer der ersten und zweiten metallischen Kontakte (21, 22, 52) eine Kontaktlänge zwischen $0,8*\sqrt{(\rho c/R2Deg)}$ und $0,9*\sqrt{(\rho c/R2Deg)}$ aufweist.

5. Elektronisches Bauteil mit Heteroübergang mit hoher Elektronenmobilität (1, 4) nach einem der vorhergehenden Ansprüche, wobei die erste Halbleitermaterialschicht (12, 42) aus GaN und die zweite Halbleitermaterialschicht (13, 43) aus AIGaN ist.

6. Elektronisches Bauteil mit Heteroübergang mit hoher Elektronenmobilität (1, 4) nach einem der vorhergehenden Ansprüche, wobei der Abstand zwischen dem ersten und dem zweiten metallischen Kontakt (21, 22, 51, 52) höchstens gleich 20 $\mu$m ist.

7. Elektronisches Bauteil mit Heteroübergang mit hoher Elektronenmobilität (1, 4) nach einem der vorhergehenden Ansprüche, wobei die ersten und zweiten metallischen Kontakte (21, 22, 51, 52) aus einem Metall sind, das aus der Liste ausgewählt wird, die aus den Legierungen von Al/Ti, Al/Ta, Al/V oder Ti/N besteht.

8. Elektronisches Bauteil mit Heteroübergang mit hoher Elektronenmobilität (1) nach einem der vorhergehenden Ansprüche, wobei die zweite Halbleitermaterialschicht (13) Aussparungen aufweist, in denen die ersten und zweiten Kontakte (21, 22) angeordnet sind.

9. Elektronisches Bauteil mit Heteroübergang mit hoher Elektronenmobilität (1) nach einem der vorhergehenden Ansprüche, wobei dieses elektronische Bauteil ein Feldeffekttransistor mit Heteroübergang ist.

10. Elektronisches Bauteil mit Heteroübergang mit hoher Elektronenmobilität (4) nach einem der Ansprüche 1 bis 8, wobei dieses elektronische Bauteil eine Diode mit Heteroübergang ist.

11. System, das enthält:

   - ein elektronisches Bauteil mit Heteroübergang mit hoher Elektronenmobilität (1) nach einem der vorhergehenden Ansprüche;
   - eine Stromversorgung (3), die konfiguriert ist, eine Potentialdifferenz anzulegen, deren maximale Amplitude zwischen 100 und 1200 Volt zwischen dem ersten und dem zweiten metallischen Kontakt (21, 22) des elektronischen Bauteils liegt.

**Claims**

1. Electronic component with a high electron mobility heterojunction (1), comprising:

   - a first layer of semiconductor material (12) superimposed on a second layer of semiconductor material (13), in a manner such as to form an electron gas layer (14) in the proximity of the interface between the first and second layers of semiconductor material;
   - first and second metallic contacts (21, 22) of conduction electrodes formed on said second layer (13) of semiconductor material vertically with respect to the electron gas layer;

   **characterized in that**:

   - at least one of said first and second metallic contacts has a contact length L such that $L \leq 1.5 * \sqrt{(\rho c / R2Deg)}$;

   in which pc is the specific resistance of said metallic contact with the electron gas layer at 425K, in which R2Deg is the sheet resistance in the electron gas layer at 425K.

2. Electronic component with a high electron mobility heterojunction (1, 4) according to Claim 1, in which at least one of said first and second metallic contacts (21, 22, 52) has a contact length L such that $L \leq 0.9 * \sqrt{(\rho c / R2Deg)}$.

3. Electronic component with a high electron mobility heterojunction (1, 4) according to Claim 2, in which at least one of said first and second metallic contacts (21, 22, 52) has a contact length L such that $L \leq 0.5 * \sqrt{(\rho c / R2Deg)}$.

4. Electronic component with a high electron mobility heterojunction (1, 4) according to Claim 2, in which at least one of said first and second metallic contacts (21, 22, 52) has a contact length comprised between $0.8 * \sqrt{(\rho c / R2Deg)}$ and $0.9 * \sqrt{(\rho c / R2Deg)}$.

5. Electronic component with a high electron mobility heterojunction (1, 4) according to any one of the preceding claims, in which the first layer of semiconductor material (12, 42) is formed from GaN, and in which the second layer of semiconductor material (13, 43) is formed from AlGaN.

6. Electronic component with a high electron mobility heterojunction (1, 4) according to any one of the preceding claims, in which the distance between said first and second metallic contacts (21, 22, 51, 52) is equal to at most 20 μm.

7. Electronic component with a high electron mobility heterojunction (1, 4) according to any one of the preceding claims, in which said first and second metallic contacts (21, 22, 51, 52) are formed from a metal selected from the list constituted by Al/Ti, Al/Ta, Al/V or Ti/N alloys.

8. Electronic component with a high electron mobility heterojunction (1) as according to any one of the preceding claims, in which said second layer of semiconductor material (13) is provided with recesses in which said first and second contacts (21, 22) are disposed.

9. Electronic component with a high electron mobility heterojunction (1) according to any one of the preceding claims, this electronic component being a heterojunction field effect transistor.

10. Electronic component with a high electron mobility heterojunction (4) according to any one of Claims 1 to 8, this electronic component being a heterojunction diode.

11. System comprising:

- an electronic component with a high electron mobility heterojunction (1) according to any one of the preceding claims;
- an electrical supply (3) configured to apply a potential difference wherein the maximum amplitude is comprised between 100 and 1200 volts between the first and second metallic contacts (21, 22) of said electronic component.

Fig. 1

Fig. 2

Fig. 3

$$\mu(T) = \mu_o(T/To)^{-2.6}$$

Fig. 4

Fig. 5

Fig. 6

Fig. 7

Fig. 8

Ronsp(L) mΩ.cm²

**Fig. 9**

**Fig. 10**

Fig. 11

Fig. 12

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- GaN-Based Super Heterojunction Field Effect Transistors Using the Polarization Junction Concept. **AKIRA NAKAJIMA et al.** IEEE ELECTRON DEVICE LETTERS. IEEE SERVICE CENTER, 01 Avril 2011, vol. 32, 542-544
- Device characteristics and performance estimation of nearly lattice-matched InAlN/AlGaN heterostructure field-effect transistors. **MIYOSHI MAKOTO et al.** Journal of Vacuum Science & Technology B: Microelectronics and Nanometer Structures. American Institute of Physics, 25 Août 2016, vol. 34

- AlGaN/GaN Schottky Diode Fabricated by Au Free Process. **JIA LIFANG et al.** IEEE ELECTRON DEVICE LETTERS. IEEE SERVICE CENTER, 01 Octobre 2013, vol. 34, 1235-1237
- C-doped semi-insulating GaN HFETs on sapphire substrates with a high breakdown voltage and low specific on-resistance. **CHOI Y et al.** JOURNAL OF VACUUM SCIENCE AND TECHNOLOGY. AVS / AIP, 15 Octobre 2007, vol. 25, 1836-1841